# EUROPEAN PATENT SPECIFICATION

(11) **EP 4 195 275 B1**
(45) Date of publication and mention of the grant of the patent: **29.04.2026**
(21) Application number: 21868227.6
(22) Date of filing: 06.07.2021
(51) Int. Cl.: H10B 12/00, H10D 1/68

(54) **DYNAMIC RANDOM ACCESS MEMORY AND MANUFACTURING METHOD THEREFOR**
DYNAMISCHER SPEICHER MIT WAHLFREIEM ZUGRIFF UND HERSTELLUNGSVERFAHREN DAFÜR
MÉMOIRE VIVE DYNAMIQUE ET SON PROCÉDÉ DE FABRICATION

(30) Priority: 16.09.2020 CN 202010974516
(43) Date of publication of application: 14.06.2023
(73) Proprietor: Changxin Memory Technologies, Inc., Hefei, Anhui 230000 (CN)
(72) Inventor: LI, Sen, Hefei, Anhui 230000 (CN); WAN, Qiang, Hefei, Anhui 230000 (CN); LIU, Tao, Hefei, Anhui 230000 (CN); XU, Penghui, Hefei, Anhui 230000 (CN)
(74) Representative: Gulde & Partner
(86) International application number: PCT/CN2021/104831
(87) International publication number: WO 2022/057398

(56) References cited:
- CN-A- 1 264 178
- CN-A- 104 037 170
- CN-A- 110 911 424
- CN-A- 111 063 270
- US-A1- 2006 134 855
- US-A1- 2006 255 391
- US-A1- 2010 187 588
- US-A1- 2010 314 710

## Description

### TECHNICAL FIELD

The present disclosure relates to the technical field of semiconductors, and in particular relates to a Dynamic Random Access Memory (DRAM) and a manufacturing method thereof.

### BACKGROUND

A DRAM is a semiconductor memory for randomly writing in and reading data at high speed, and is widely applied to a data storage apparatus or device. The DRAM may generally include a substrate and connection pads and capacitors disposed on the substrate. Herein, the connection pad is provided with a bottom surface towards the substrate and a top surface away from the substrate, and an end, close to the substrate, of a first electrode layer of the capacitor is electrically connected with the top surface of the connection pad.

However, contact resistance between the first electrode layer of the capacitor and the connection pad is relatively high, thereby causing signal delay easily and influencing the performance of the DRAM. Moreover, in a process of forming a capacitive structure, as a capacitive hole has a high depth-to-width ratio, the collapse risk of the capacitor is relatively easy to occur in a subsequent manufacturing process. Background may be found in US2010/187588A1, US US2006/134855A1 and US2006/255391A1.

### SUMMARY

A manufacturing method of a Dynamic Random Access Memory according to the invention is presented in claim 1. Embodiments of the invention are presented in the dependent claims.

The embodiments of the present disclosure provide a DRAM and a manufacturing method thereof, used for reducing contact resistance between capacitors and connection pads, reducing signal delay, improving the performance of the DRAM, meanwhile, improving the acting force between capacitive holes and the connection pads, and reducing the collapse risk of the capacitors in a subsequent manufacturing process.

Besides the above described technical problems solved by the embodiments of the present disclosure, technical features constituting the technical solutions and beneficial effects of the technical features of these technical solutions, other technical problems solved by the DRAM and the manufacturing method thereof provided by the embodiments of the present disclosure, other technical features included in the technical solutions and beneficial effects of these technical features will be further described in detail in specific implementation modes.

### BRIEF DESCRIPTION OF THE DRAWINGS

FIG. 1 is a schematic structural diagram of a DRAM in a related art.
FIG. 2 is a first schematic structural diagram of a DRAM.
FIG. 3 is a second schematic structural diagram of a DRAM.
FIG. 4 is a first flowchart of a manufacturing method of a DRAM.
FIG. 5 is a schematic diagram of forming dielectric structures and connection pads in a manufacturing method of a DRAM.
FIG. 6 is a top view of forming dielectric structures and connection pads in a manufacturing method of a DRAM.
FIG. 7 is a second flowchart of a manufacturing method of a DRAM.
FIG. 8 is a schematic diagram of forming a first stacked structure in a manufacturing method of a DRAM.
FIG. 9 is a third flowchart of a manufacturing method of a DRAM.
FIG. 10 is a schematic diagram of forming first protusions in a manufacturing method of a DRAM.
FIG. 11 is a top view of forming first protusions in a manufacturing method of a DRAM.
FIG. 12 is a schematic diagram of forming an etching layer in a manufacturing method of a DRAM.
FIG. 13 is a top view of forming an etching layer in a manufacturing method of a DRAM.
FIG. 14 is a first schematic diagram of forming annular grooves in a manufacturing method of a DRAM.
FIG. 15 is a fourth flowchart of a manufacturing method of a DRAM.
FIG. 16 is a second schematic diagram of forming annular grooves in a manufacturing method of a DRAM.
FIG. 17 is a schematic diagram of patternizing a first photoresist layer in a manufacturing method of a DRAM.
FIG. 18 is a top view of patternizing a first photoresist layer in a manufacturing method of a DRAM.
FIG. 19 is a first schematic diagram of forming a filler layer in a manufacturing method of a DRAM.
FIG. 20 is a second schematic diagram of forming a filler layer in a manufacturing method of a DRAM.
FIG. 21 is a first schematic diagram of forming a second stacked structure in a manufacturing method of a DRAM.
FIG. 22 is a second schematic diagram of forming a second stacked structure in a manufacturing method of a DRAM.
FIG. 23 is a fifth flowchart of a manufacturing method of a DRAM.
FIG. 24 is a first schematic diagram of forming openings in a manufacturing method of a DRAM.
FIG. 25 is a second schematic diagram of forming openings in a manufacturing method of a DRAM.
FIG. 26 is a first schematic diagram of forming capacitive holes and annular grooves in a manufacturing method of a DRAM.
FIG. 27 is a second schematic diagram of forming capacitive holes and annular grooves in a manufacturing method of a DRAM.
FIG. 28 is a top view of forming capacitive holes and annular grooves in a manufacturing method of a DRAM.
FIG. 29 is a first schematic diagram of forming a first electrode layer and an extension part in a manufacturing method of a DRAM.
FIG. 30 is a second schematic diagram of forming a first electrode layer and an extension part in a manufacturing method of a DRAM.
FIG. 31 is a top view of forming a first electrode layer and an extension part in a manufacturing method of a DRAM.
FIG. 32 is a sixth flowchart of a manufacturing method of a DRAM.
FIG. 33 is a schematic structural diagram of forming second opening regions in a manufacturing method of a DRAM.

### DETAILED DESCRIPTION

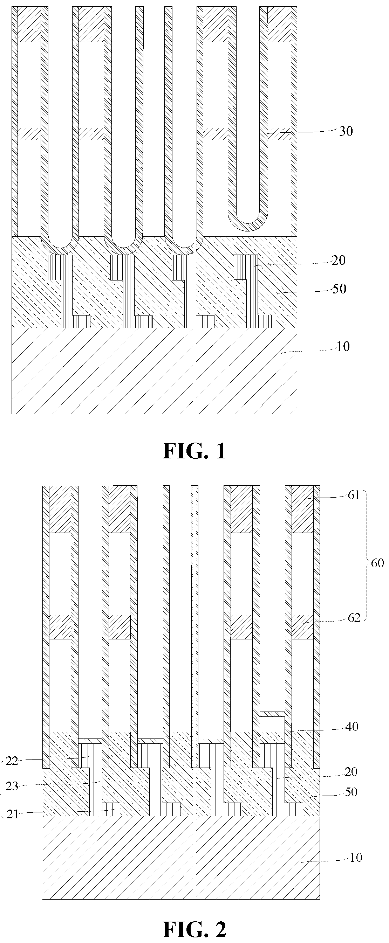

In an actual working process, the inventor of the present disclosure finds that: as illustrated in FIG. 1, an end, close to a substrate 10, of a first electrode layer 30 of each capacitor is disposed on a top surface of a respective connection pad 20. A contact area between the first electrode layer 30 and the connection pad 20 is relatively small, which results in that contact resistance between the first electrode layer 30 and the connection pad 20 is relatively large, and the contact resistance will cause a DRAM to have signal delay, thereby reducing the performance of the DRAM.

Moreover, when a capacitive hole of the capacitor has a high depth-to-width ratio and a contact area between the first electrode layer 30 and the connection pad 20 is relatively small, the collapse risk of the capacitive hole easily occurs, thereby influencing the performance of the DRAM.

Aiming at the above technical problems, the embodiments of the present disclosure provide a DRAM and a manufacturing method thereof. As an extension part extending towards a substrate is disposed on a first electrode layer, and the extension part is coated on a top surface and a side surface of a connection pad at the same time, a contact area between the first electrode layer and the connection pad may be increased, contact resistance between the first electrode layer and the connection pad may be reduced, thus signal delay of the DRAM may be reduced, and the performance of the DRAM may be improved. Meanwhile, the extension part may also increase the acting force between the capacitive hole and the connection pad, so that the collapse risk of the capacitor in the subsequent manufacturing process is reduced.

In order to make the above objectives, features and advantages of the embodiments of the present disclosure more apparent and understandable, the technical solutions in the embodiments of the present disclosure will be clearly and completely described below in combination with the drawings in the embodiments of the present disclosure. It is apparent that the described embodiments are not all embodiments but merely part of embodiments of the present disclosure.

### First embodiment

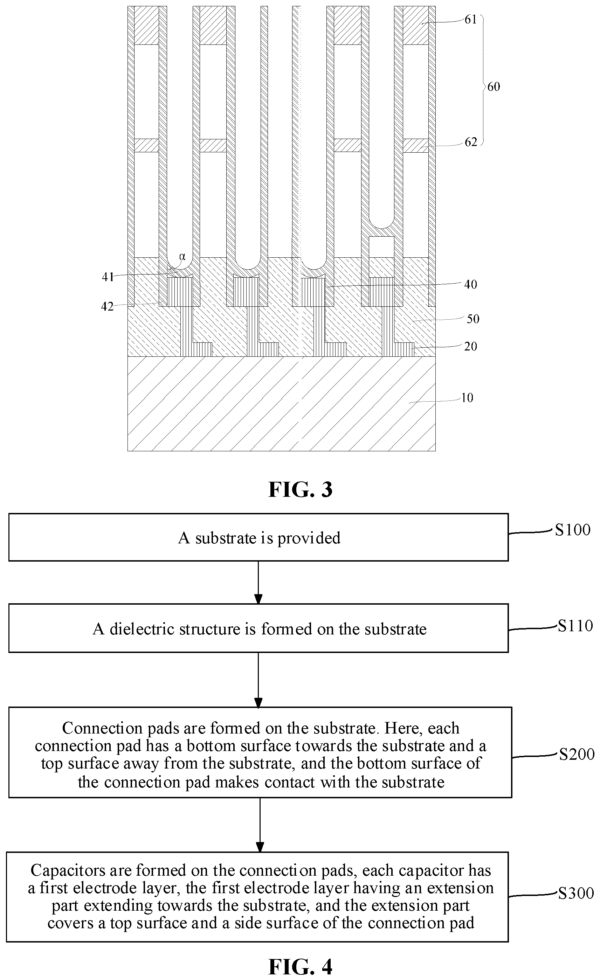

As illustrated in FIG. 2 and FIG. 3, the embodiments of the present disclosure provide a DRAM, which includes a substrate 10, the substrate 10 serving as a supporting part of the DRAM and configured to support other parts disposed thereon, herein, the substrate 10 may be made of a semiconductor material, and the semiconductor material may be one or more of silicon, germanium, a silicon germanium compound and a silicon carbon compound.

Connection pads 20 and capacitors electrically connected with the respective connection pad 20 are disposed on the substrate 10. The connection pad 20 has a bottom surface towards the substrate 10 and a top surface away from the substrate 10. Herein, the bottom surface of the connection pad 20 makes contact with the substrate 10, so that the capacitor is electrically connected with an active region of the substrate 10, and thus signal transmission between the active region of the substrate 10 and the capacitors is realized.

The contact between the bottom surface of the connection pad 20 and the substrate 10 may be understood as direct contact or indirect contact. For example, necessary structures of the DRAM such as transistors, word lines and capacitor contact windows (not illustrated in the figure) may be disposed in the substrate 10. Herein, an end of the capacitor contact window is electrically connected with the active region of the substrate 10, and the other end of the capacitor contact window is electrically connected with the bottom surface of the connection pad 20. Through arrangement of the capacitor contact window in the embodiment, electrical connection between the capacitor and the active region in the substrate 10 may be realized, and signal transmission is convenient.

The active region of the substrate 10 refers to a region used for setting signal routing, which is used for being electrically connected with the capacitor and providing a control signal for the capacitor. Moreover, there may be a plurality of active regions of the substrate 10, an isolation structure is disposed among the plurality of active regions, and the isolation structure is configured to enable adjacent active regions to be insulated mutually.

In the embodiment, as the connection pad 20 is disposed between the capacitor contact window and the capacitor, a contact area between the capacitor contact window and the capacitor may be increased by utilizing the connection pad 20, so that contact resistance between the capacitor contact window and the capacitor is reduced, thus, signal delay of the DRAM is reduced, and the performance of the DRAM is improved. Moreover, areas of the top surface and the bottom surface of the connection pad 20 are greater than a contact area between the capacitor contact window and the capacitor. Due to the design, in a process of manufacturing the DRAM, the alignment speed of the capacitor and the connection pad is greater than the direct alignment speed of the capacitor and the capacitor contact window, so that the manufacturing efficiency is increased.

The capacitor includes a first electrode layer 30, the first electrode layer 30 is provided with an extension part 40 extending towards the substrate, and the extension part 40 is coated on a top surface and a side surface of the connection pad 20, so that a contact area between the first electrode layer 30 and the connection pad 20 may be increased, contact resistance between the first electrode layer 30 and the connection pad 20 may be reduced, thus signal delay of the DRAM may be reduced, and the performance of the DRAM may be improved. Moreover, due to increasing of a contact area between the first electrode layer 30 and the connection pad 20, collapse of the capacitor may be effectively prevented in a subsequent process.

The extension part 40 and the first electrode layer 30 of the capacitor may be made of the same material, so that the first electrode layer 30 of the capacitor may be ensured to have basically same resistance at various positions, signal delay of the DRAM is reduced, and the performance of the DRAM is improved. For example, the extension part 40 and the first electrode layer 30 may be one or more of titanium nitride, tungsten, tungsten titanium, aluminum, copper or metal silicide.

The extension part 40 and the first electrode layer 30 may be an integrated structure and may also be a split structure. When the extension part 40 and the first electrode layer 30 may be an integrated structure, the first electrode layer 30 and the extension part 40 may be manufactured by adopting a same manufacturing process at the same time, so that the manufacturing process of the first electrode layer 30 and the extension part 40 is simplified, and the production cost is reduced.

The shape of the extension part 40 is adaptive to the shape of a joint of the connection pad 20 and the extension part 40. For example, the shape of the joint of the connection pad 20 and the extension part 40 is cylindrical, correspondingly, the shape of the extension part 40 may be a circular structure with an opening, at least part of the connection pad 20 extends into the circular structure, so that the side surface of the connection pad 20 is attached to the inside surface of the circular structure, i.e., the circular structure covers at least part of the side surface of the connection pad 20.

In some embodiments, continuously referring to FIG. 3, the extension part 40 may include a first extension part 41 and a second extension part 42, the first extension part 41 is coated on a top surface of the connection pad 20, the second extension part 42 is coated on a side surface of the connection pad 20, and the first extension part 41 and the second extension part 42 have an included angle, which is between 50 degrees and 90 degrees.

Herein, the included angle is alpha as illustrated in FIG. 3. The included angle between the first extension part 41 and the second extension part 42 is limited by the embodiment. When the included angle is 90 degrees, a bottom surface of the first extension part 41 is completely attached to a top surface of the connection pad, so that a contact area between the extension part 40 and the connection pad 20 may be increased to the most extent. While contact resistance between the first electrode layer 30 and the connection pad 20 is reduced and signal delay is reduced, the acting force between the first electrode layer 30 and the connection pad 20 may also be increased, thereby preventing collapse of the capacitor.

In some embodiments, the connection pad 20 may include a first connection part 21, a second connection part 22 and a transition part 23, herein, the transition part 23 is disposed between the first connection part 21 and the second connection part 22, an end of the transition part 23 is connected with the first connection part 21, and the other end of the transition part 23 is connected with the second connection part 22.

The first connection part 21 is electrically connected with the capacitor contact window, the second connection part 22 is electrically connected with the first electrode layer 30, electrical connection between the capacitor contact window and the first electrode layer 30 is realized through the connection pad 20, so that a signal of the active region on the substrate 10 is transmitted to the capacitor, and thus the storage function of the capacitor is realized.

In the connection pad 20, a plane parallel to the substrate 10 is used as a section, the sectional area of the transition part 23 is smaller than the sectional area of the first connection part 21 and smaller than the sectional area of the second connection part 22. In the embodiment, the transition part 23 is configured to realize connection between the first connection part 21 and the second connection part 22, and cannot make direct contact with the capacitor contact window or the first electrode layer 30, therefore, the sectional area of the transition part 23 in the embodiment is relatively small, so that the area occupied by the connection pad 20 may be reduced, and thus the size of the DRAM is reduced. Meanwhile, the sectional area of the first connection part 21 and the sectional area of the second connection part 22 are larger than the sectional area of the transition part 23, in a process of manufacturing the DRAM, the connection pad and the capacitor contact window may be aligned rapidly, and the capacitor and the connection pad may be aligned rapidly, so that the manufacturing efficiency is increased.

Moreover, as the sectional area of the first connection part 21 is larger than the sectional area of the transition part 23, a contact area between the first connection part 21 and the capacitor contact window may be increased, the contact resistance between the first connection part 21and the capacitor contact window may be reduced, so that the signal delay between the first connection part 21 and the capacitor contact window is reduced, and the performance of the DRAM is improved. As the sectional area of the second connection part 22 is larger than the sectional area of the transition part 23, a contact area between the second connection part 22 and the first electrode layer 30 may be increased, the contact resistance between the second connection part 22 and the first electrode layer 30 may be reduced, so that signal delay between the second connection part 22 and the first electrode layer 30 is reduced, and the performance of the DRAM is improved.

The extension part 40 in the embodiment may cover a top surface, where the second connection part 22 makes contact with the first electrode layer 30, and a side surface of the second connection part 22, so that a contact area between the second connection part 22 and the first electrode layer 30 may be increased, contact resistance between the second connection part 22 and the first electrode layer 30 may be reduced, thus, signal delay between the second connection part 22 and the first electrode layer 30 is reduced, and the performance of the DRAM is improved.

The operation that the extension part 40 covers the side surface of the second connection part 22 may be understood as: the extension part 40 surrounds the second connection part 22, and the inside surface of the extension part 40 is attached to the side surface of the second connection part 22.

The bottom surface of the extension part 40 may be aligned to the bottom surface of the second connection part 22, at this time, the extension part 40 covers all regions of the side surface of the second connection part 22. The extension part 40 and the bottom surface of the second connection part 22 may also be separated by a predetermined distance, at this time, the extension part 40 covers part of regions of the side surface of the second connection part 22.

The DRAM provided by the embodiments may also include a dielectric structure 50, the dielectric structure 50 is disposed between the substrate 10 and the capacitor, moreover, the connection pad 20 is disposed in the dielectric structure 50, so that the connection pad 20 may be insulated from other parts, and normal operation of the DRAM is ensured. Herein, other parts may be parts in the DRAM, besides the capacitor and parts in the active region.

Herein, the dielectric structure 50 may include a single film layer and may also include a plurality of film layers that are stacked in sequence. When the dielectric structure 50 may include the plurality of film layers, materials of adjacent film layers may be same and may also be different. Exemplarily, the dielectric structure 50 may include three film layers that are stacked in sequence, and materials of the three film layers may be silicon oxide, silicon nitride and silicon oxynitride.

In some embodiments, the capacitor may also include a second electrode layer (not illustrated in the figure), which is disposed in a layer different from a layer of the first electrode layer 30, and the capacitor may also include a dielectric layer (not illustrated in the figure), which is disposed between the first electrode layer 30 and the second electrode layer.

The second electrode layer is disposed on one side, away from the substrate 10, of the first electrode layer 30, and has an overlapped region with the first electrode layer 30, so that capacitance will be formed between the first electrode layer 30 and the second electrode layer for data storage.

In the embodiment, the condition that the first electrode layer 30 and the second electrode layer have the overlapped region may be understood as: a projection of the second electrode layer on the first electrode layer 30 is completely superposed with the first electrode layer 30, or partly superposed.

There are many choices of shapes of the first electrode layer 30 and the second electrode layer. For example, the first electrode layer and the second electrode layer may be two square plate bodies disposed in different layers. For another example, by taking a plane vertical to the substrate as a longitudinal section, the shape of the longitudinal section of the first electrode layer 30 may be a U shape with a top opening. As illustrated in FIG. 2, the bottom surface of the first electrode layer 30 and the top surface of the connection pad 20 are in line contact. For another example, the shape of the longitudinal section of the first electrode layer 30 may be rectangular with a top opening, i.e., as illustrated in FIG. 3, the bottom surface of the first electrode layer 30 is attached to the top surface of the second connection part 22, so that a contact area between the first electrode layer 30 and the connection pad 20 may be increased, and contact resistance between the first electrode layer 30 and the connection pad 20 may be reduced.

The dielectric layer is configured to realize insulation between the first electrode layer 30 and the second electrode layer, herein, the material of the dielectric layer may be one or more of silicon oxide, silicon nitride and silicon oxynitride.

In some embodiments, the DRAM disclosed by the embodiment may include a plurality of capacitors, the plurality of capacitors are disposed on the dielectric structure 50 at intervals, moreover, a supporting layer 60 is disposed between adjacent capacitors, herein, on one hand, the plurality of capacitors may be separated by the supporting layer 60, so that the plurality of capacitors may be controlled independently, on the other hand, the supporting layer 60 may also be configured to support the capacitors, so that the structural strength of the capacitors is improved.

As illustrated in FIG. 3, each of the capacitors is provided with a bottom towards the substrate and a top away from the substrate, the supporting layer 60 may include a top supporting layer 61, an intermediate supporting layer 62 and a bottom supporting layer (not illustrated in the figure), herein, the top supporting layer 61 is located among a plurality of capacitors, moreover, the top surface of the top supporting layer 61 is aligned to the top of the capacitor, the bottom surface of the top supporting layer 61 and the dielectric structure 50 are disposed at intervals, the intermediate supporting layer 62 is located between the top supporting layer 61 and the dielectric structure 50, and the bottom supporting layer is disposed in the dielectric structure 50. A three-point support mode is adopted in the embodiment, so that the structural strength of the capacitor may be ensured.

### Second embodiment

The embodiments of the present disclosure further provide a manufacturing method of a DRAM, which may include the following steps.

At S100, a substrate 10 is provided.

Herein, the substrate 10 is used as a supporting part of the DRAM and configured to support other parts disposed thereon, herein, the substrate 10 may be made of a semiconductor material, for example, the semiconductor material may be one or more of silicon, germanium, a silicon germanium compound and a silicon carbon compound.

At S200, connection pads 20 is formed on the substrate 10. The connection pad 20 has a bottom surface towards the substrate 10 and a top surface away from the substrate 10, and the bottom surface of the connection pad 20 makes contact with the substrate 10.

Herein, the material of the connection pads 20 may be one or more of titanium nitride, tungsten, tungsten titanium, aluminum, copper or metal silicide, so that electrical connection between an active region of the substrate and capacitors is realized.

Exemplarily, before the step of forming the connection pads 20 on the substrate 10, the operation may also include S110.

As illustrated in FIG. 4, a dielectric structure 50 is formed on the substrate 10, afterwards, the connection pads 20 are formed in the dielectric structure 50, through arrangement of the dielectric structure 50, mutual insulation among the connection pads 20 and other parts on the substrate 10 besides the active region may be ensured.

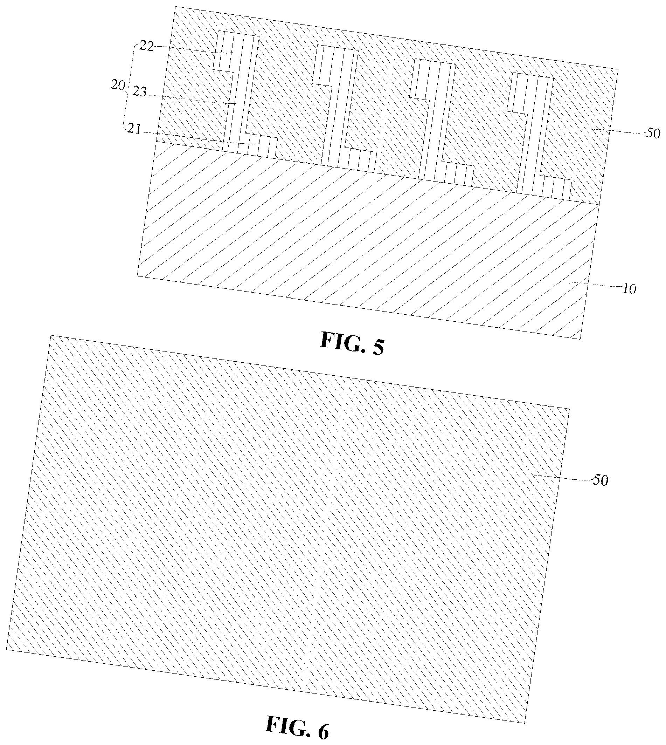

In the step, a layer of dielectric structure may be deposited on the substrate through chemical deposition, physical deposition or an evaporation mode, then, connecting holes for containing the respective connection pads are formed on the dielectric structure by adopting a composition process, and a conductive material is deposited in the connecting hole in a deposition manner to form the connection pads at last. Structures of the dielectric structure 50 and the connection pads 20 in the embodiment are as illustrated in FIG. 5 and FIG. 6.

At S300, capacitors are formed on the respective connection pads 20. The capacitor has a first electrode layer 30, the first electrode layer 30 has an extension part 40 extending towards the substrate 10, and the extension part 40 covers a top surface and a side surface of the connection pad 20.

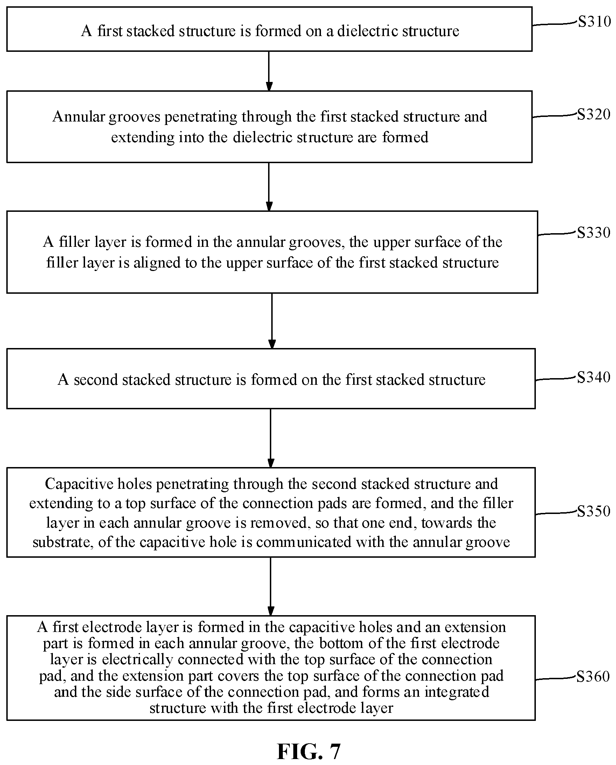

The S300 may be carried out by adopting a manner illustrated in a process flowchart in FIG. 7. Exemplarily.

At S310, a first stacked structure 70 is formed on the dielectric structure 50.

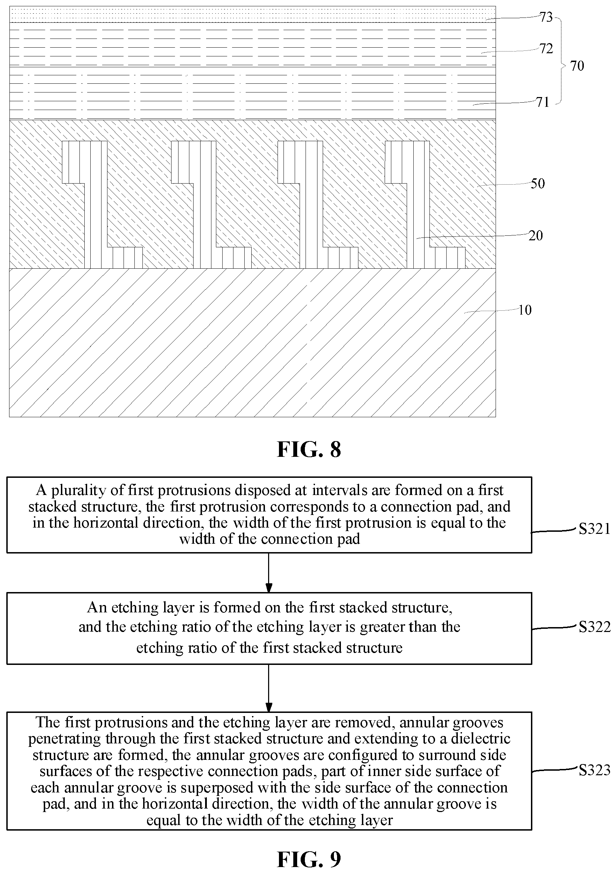

In the step, the first stacked structure 70 may be formed on the dielectric structure 50 through an atomic layer deposition process or a chemical vapor deposition process, herein, the first stacked structure 70 may include a first oxide layer 71, a first mask layer 72 and a first silicon oxynitride layer 73, thereby forming a structure as illustrated in FIG. 8. It is to be noted that the first oxide layer 71 in the embodiment may be silicon oxide or zirconium oxide.

At S320, an annular groove penetrating through the first stacked structure 70 and extending into the dielectric structure 50 is formed.

Exemplarily, as illustrated in FIG. 9, the S320 may include the following steps.

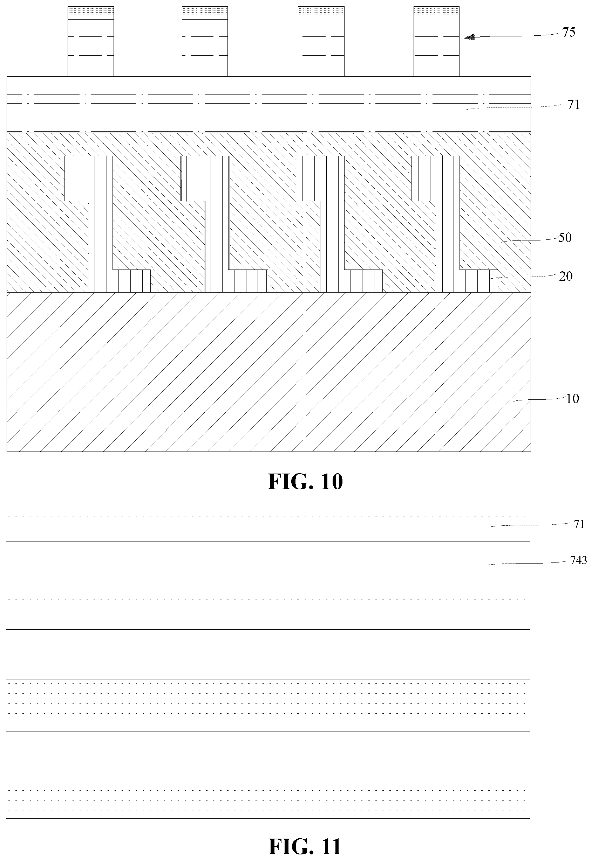

At S321, a plurality of first protusions 75 disposed at intervals are formed on the first stacked structure 70, as the plurality of first protusions 75 disposed at intervals are formed on the first stacked structure and the first protusion 75 corresponds to the connection pad 20, and in the horizontal direction, the width of the first protusion 75 is equal to the width of the connection pad 20, thereby forming a structure as illustrated in FIG. 10 and FIG. 11.

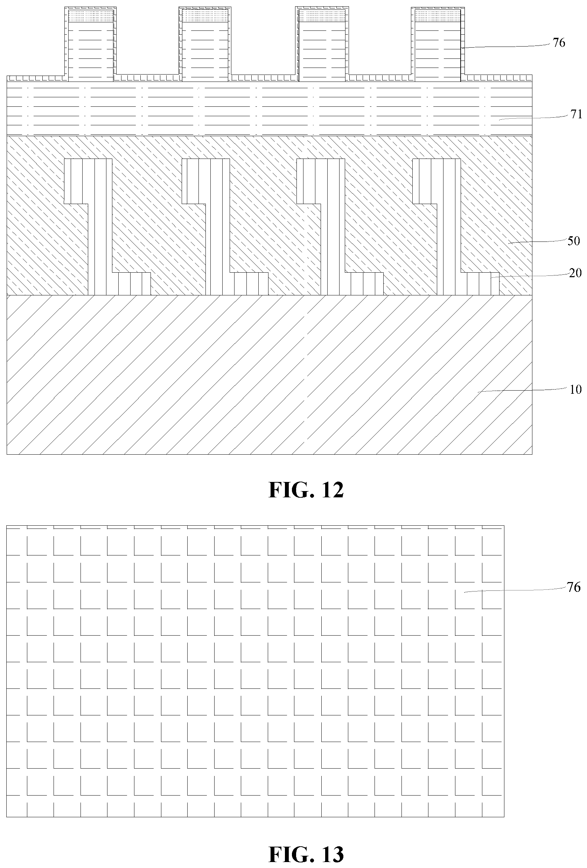

At S322, an etching layer 76 is formed on the first stacked structure 70, thereby forming a structure as illustrated in FIG. 12 and FIG. 13. In the step, the etching ratio of the etching layer 76 is greater than the etching ratio of the first stacked structure 70.

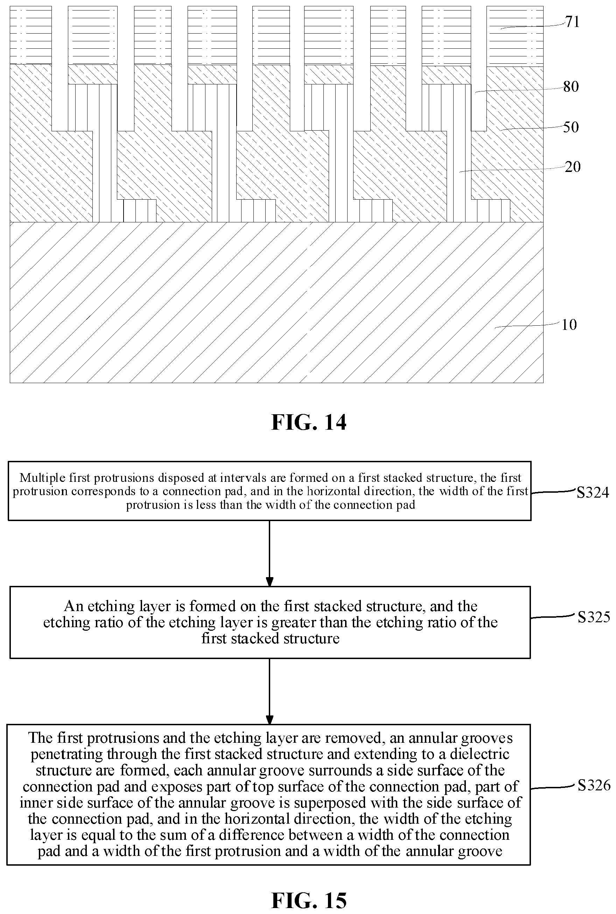

At S323, the first protusions 75 and the etching layer 76 are removed, and the annular grooves 80 penetrating through the first stacked structure 70 and extending to the dielectric structure 50 are formed. As illustrated in FIG. 14, the annular groove 40 is configured to surround a side surface of the connection pad 20, part of inner side surface of the annular groove 80 is superposed with the side surface of the connection pad 20, and in the horizontal direction, the width of the annular groove 80 is equal to the width of the etching layer 76.

In the step, the process of forming the annular grooves 80 is carried out by adopting a Self-Aligned Double Patterning (SADP) process.

Exemplarily, as illustrated in FIG. 15, the S320 may include the following steps.

At S324, the plurality of first protusions 75 disposed at intervals are formed on the first stacked structure 70, the first protusions 75 corresponds to the connection pads 20, and in the horizontal direction, the width of the first protusion 75 is less than the width of the connection pad 20.

At S325, the etching layer 76 is formed on the first stacked structure 70, and the etching ratio of the etching layer 76 is greater than the etching ratio of the first stacked structure 70.

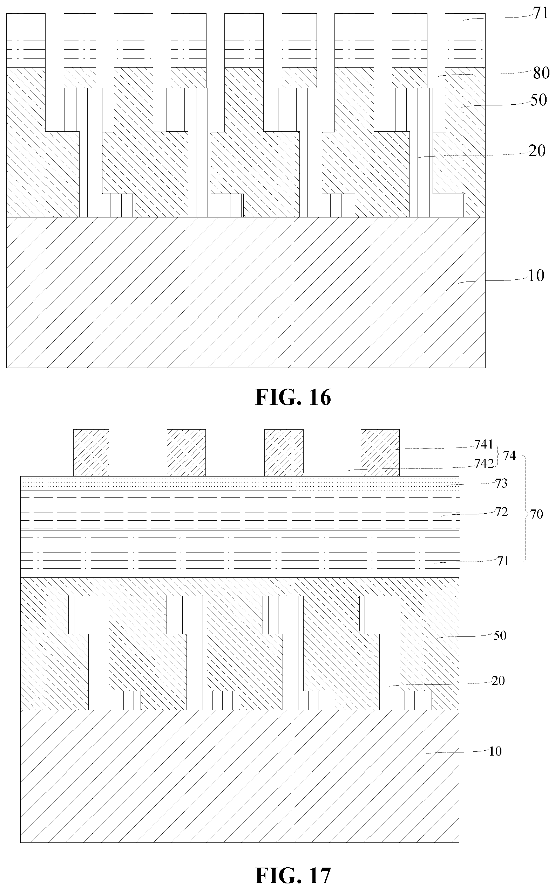

At S326, the first protusions 75 and the etching layer 76 are removed, the annular grooves 80 penetrating through the first stacked structure 70 and extending to the dielectric structure 50 are formed, the annular groove 80 surrounds a side surface of the connection pad 20 and exposes part of top surface of the connection pad 20, part of inner side surface of the annular groove 80 is superposed with the side surface of the connection pad 20, and in the horizontal direction, the width of the etching layer 76 is equal to the sum of a width difference of the connection pad 20 and the first protusion 75 and the width of the annular groove 80, the structure of which is as illustrated in FIG. 16.

In the step, the process of forming the annular grooves 80 is carried out by adopting the SADP process.

In some embodiments, the step of forming the first stacked structure 70 on the dielectric structure 50 may include: the first oxide layer 71, the first mask layer 72 and the first silicon oxynitride layer 73 are stacked on the dielectric structure 50 in sequence, thereby forming a structure as illustrated in FIG. 8.

The step of forming the plurality of first protusions 75 disposed at intervals on the first stacked structure 70 may include the following operations.

At S3211, a first photoresist layer 74 is formed on the first silicon oxynitride layer 73.

The first photoresist layer 74 may be formed on the first silicon oxynitride layer 73 by adopting a coating-curing method, an ink jet printing method or a deposition method, the first photoresist layer 74 covering an upper surface of the first silicon oxynitride layer 73.

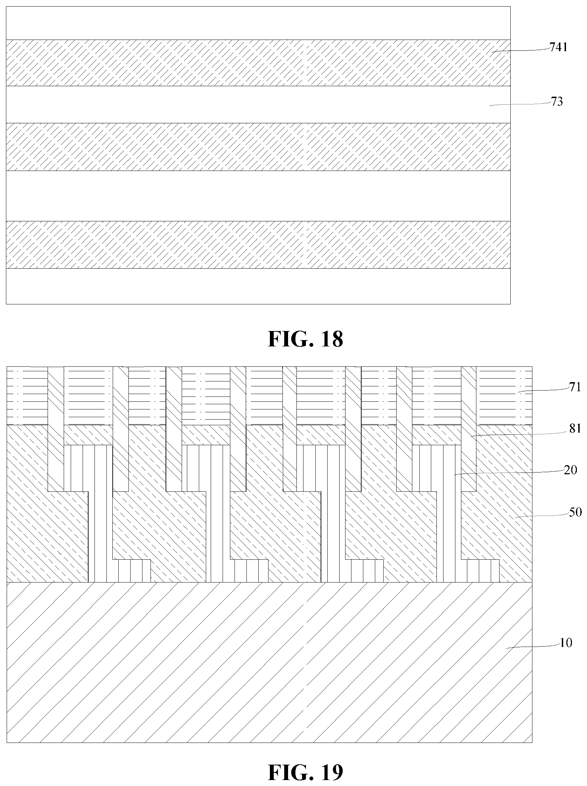

At S3212, the first photoresist layer 74 is patternized to form a first mask pattern, as illustrated in FIG. 17 and FIG. 18, the first mask pattern may include a plurality of first blocking regions 741 and a plurality of first opening regions 742 that are alternately disposed, and the plurality of first blocking regions 741 and the connection pads 20 are in one-to-one correspondence.

The first photoresist layer is patternized through patternizing treatment manners such as masking, exposing, developing and etching to form a mask pattern, i.e., a plurality of grooves disposed at intervals are formed on the first photoresist layer.

At S3213, the first mask layer 72 and the first silicon oxynitride layer 73 corresponding to the first opening region 742 are removed, the plurality of first protusions 75 disposed on the first oxide layer 71 at intervals are formed, and the plurality of first protusions and the connection pads are in one-to-one correspondence.

In the step, the first mask layer 72 and the first silicon oxynitride layer 73 required to be removed are eliminated by utilizing a cleaning process such as an ultrasonic cleaning method or a plasma cleaning method, so that a first mask layer 52 and the first silicon oxynitride layer 73 correspondingly disposed with the blocking region 741 are retained, thereby forming a structure as illustrated in FIG. 10.

At S330, a filler layer 81 is formed in the annular grooves 80, the upper surface of the filler layer 81 is aligned to the upper surface of the first stacked structure 70, i.e., the upper surface of the filler layer 81 is aligned to the upper surface of the first oxide layer 71.

When the annular groove 80 is configured to surround the side surface of the connection pad 20, part of inner side surface of the annular groove 80 is superposed with the side surface of the connection pad 20, and the formed filler layer 81 is circular, as illustrated in FIG. 19.

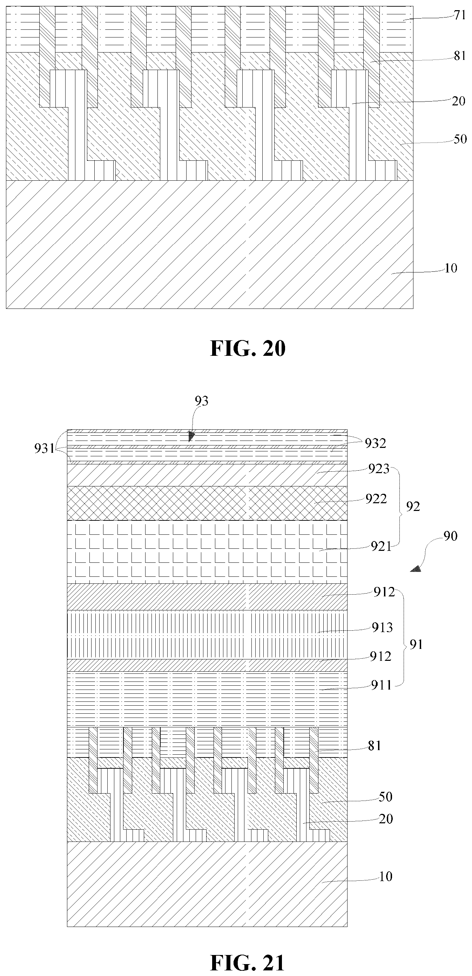

When the annular groove 80 surrounds the side surface of the connection pad 20 and exposes part of top surface of the connection pad 20, the section of the formed filler layer 81 is converse L-shaped, as illustrated in FIG. 20.

Herein, the filler layer 81 may be amorphous carbon, or, the filler layer 81 may be another medium layer, and the etching ratio of the medium layer is greater than the etching ratio of the dielectric structure.

At S340, a second stacked structure 90 is formed on the first stacked structure 70.

In the step, the second stacked structure 90 may be formed on the first stacked structure 70 through an atomic layer deposition process or a chemical vapor deposition process, i.e., the second stacked structure 90 is formed on the first oxide layer 71 through the atomic layer deposition process or the chemical vapor deposition process.

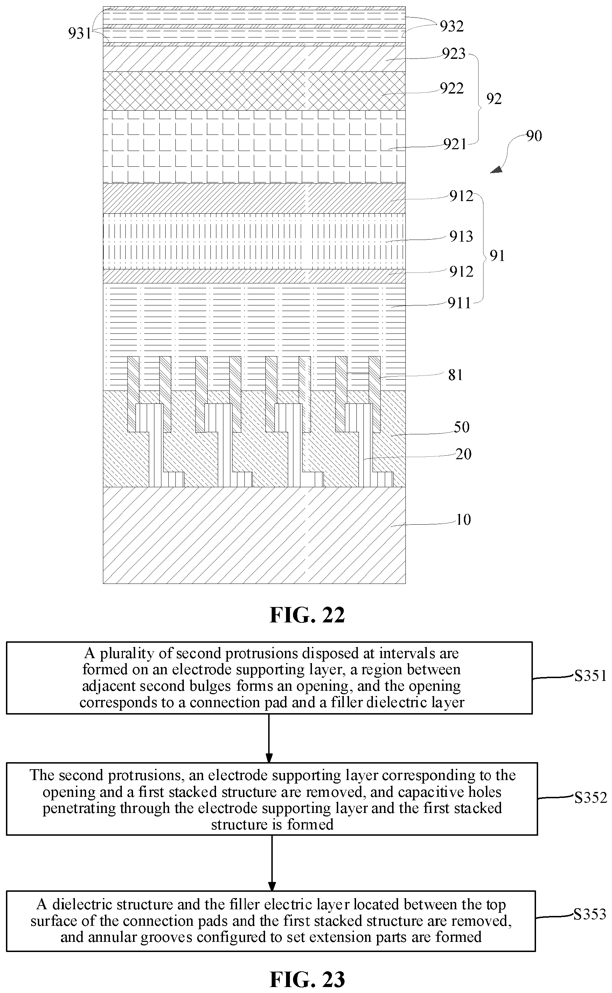

As illustrated in FIG. 21 and FIG. 22, the second stacked structure 90 may include an electrode supporting layer 91, a sacrificial layer 92 and a mask layer group 93 that are stacked in sequence, and the electrode supporting layer 91 is disposed on the first oxide layer 71.

The electrode supporting layer 91 may be a film layer composed of a single material, for example, the material of the electrode supporting layer 91 is silicon nitride. For another example, the electrode supporting layer 91 may be a plurality of film layers, moreover, materials of the various film layers are different, exemplarily, the electrode supporting layer 91 may include a second oxide layer 911, a silicon nitride layer 912, a third oxide layer 913 and a silicon nitride layer 912 that are stacked on the first stacked structure 70 in sequence, herein, the material of the second oxide layer 911 and the material of the third oxide layer 913 may be same and may also be different.

The sacrificial layer 92 may include a polycrystalline silicon layer 921, a fourth oxide layer 922 and a first carbon layer 923, and the polycrystalline silicon layer 921 is disposed on a side surface, departing from the third oxide layer 913, of the silicon nitride layer 912.

The mask layer group 93 may include a second silicon oxynitride layer 931, a second mask layer 932, a second silicon oxynitride layer 931 and a second mask layer 932 that are stacked in sequence.

In the embodiment, the etching ratio of the electrode supporting layer 91 is greater than the etching ratio of the sacrificial layer 92, and the etching ratio of the sacrificial layer 92 is greater than the etching ratio of the mask layer group 93. Because the etching ratio of the electrode supporting layer 91 is the largest, at the same etching speed, the etching depth of the electrode supporting layer 91 is the largest, so that a groove extending towards the substrate will be formed on the electrode supporting layer 91 in a subsequent etching process.

At S350, capacitive holes 31 penetrating through the second stacked structure 90 and extending to top surfaces of the respective connection pads 20 are formed, and the filler layer 81 in the annular grooves 80 is removed, so that an end, towards the substrate, of each capacitive hole 31 is communicated with the annular groove.

Exemplarily, as illustrated in FIG. 23, the S350 may include the following steps.

At S351, a plurality of second protusions disposed at intervals are formed on the electrode supporting layer 91, a region between adjacent second protusions forms an opening 924, and each opening 924 corresponds to a respective connection pad 20 and the filler layer 81.

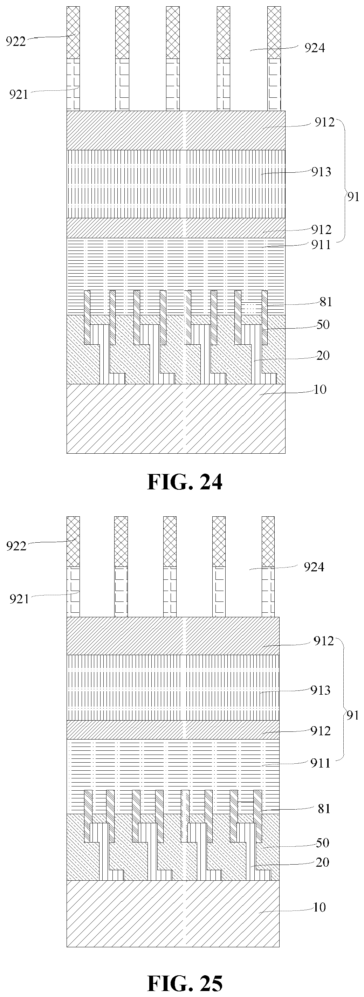

In the step, because the etching ratio of the sacrificial layer 92 is greater than the etching ratio of the mask layer group 93, at the same etching speed, the mask layer group 93 will be completely etched away, moreover, a plurality of openings 924 are formed on the sacrificial layer 92, the second protusion is formed between adjacent openings 924, and each opening 924 corresponds to a respective connection pad 20 and the filler layer 81, thereby forming a structure as illustrated in FIG. 24 and FIG. 25.

At S352, the second protusions, the electrode supporting layer 91 corresponding to the opening 924 and the first stacked structure 70 are removed, and the capacitive holes 31 penetrating through the electrode supporting layer 91 and the first stacked structure 70 are formed.

Etching is continuously carried out by utilizing a high-selectivity anisotropic dry etching process, so that the opening 924 continuously extends downwardly till to penetrate through the electrode supporting layer 91 and the first stacked structure 70.

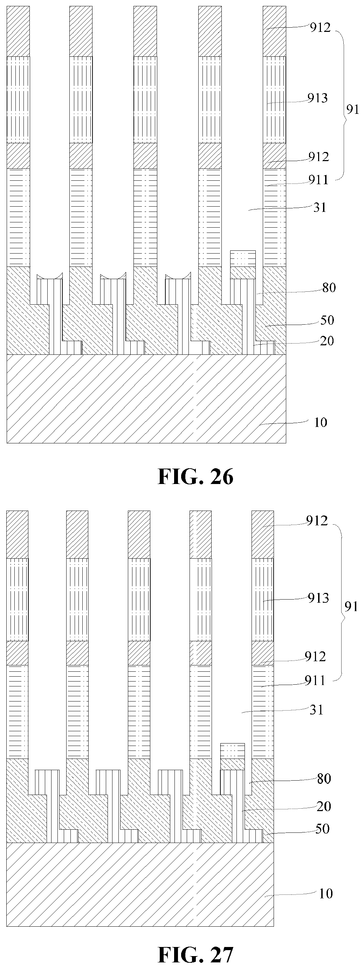

At S353, the dielectric structure 50 and the filler layer 81 located between the top surface of the connection pad 20 and the first stacked structure 70 are removed, and the annular groove 80 configured to set the extension part 40 is formed, thereby forming a structure as illustrated in FIG. 26, FIG. 27 and FIG. 28.

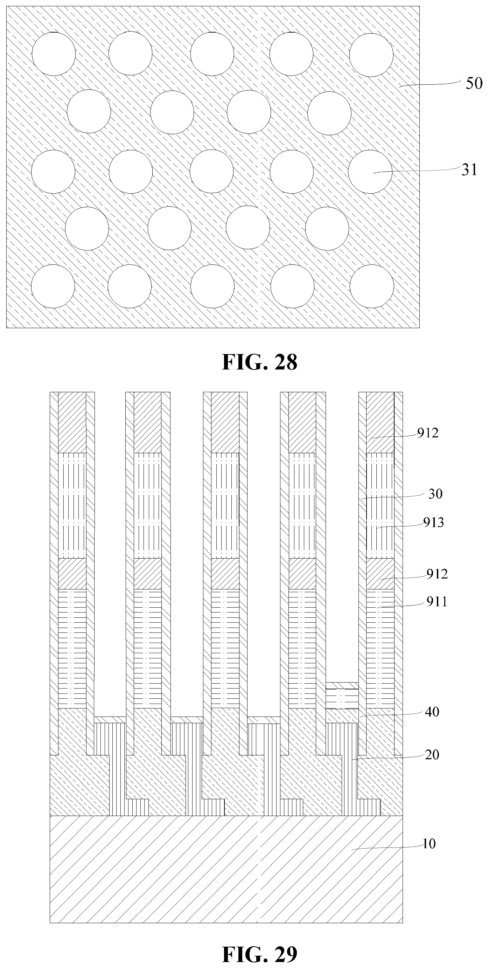

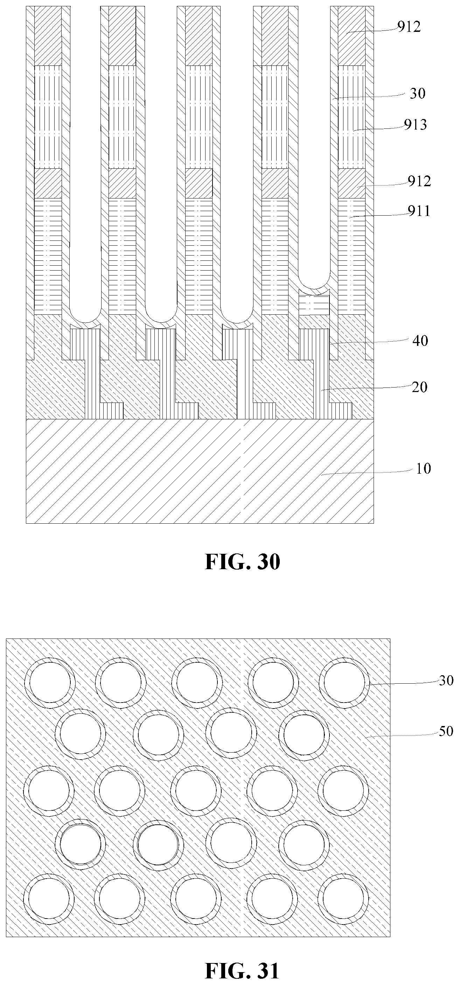

At S360, the first electrode layer 30 is formed in the capacitive hole 31 and the extension part 40 is formed in the annular groove 80, and the bottom of the first electrode layer 30 is electrically connected with the top surface of the connection pad 20. The extension part 40 covers the top surface of the connection pad 20 and the side surface of the connection pad 20, and forms an integrated structure with the first electrode layer 30, thereby forming a structure as illustrated in FIG. 29, FIG. 30 and FIG. 31.

The material of the first electrode layer 30 is deposited on the side wall of the capacitive hole 31, in the annular groove 80 and on the top surface of the connection pad 20 by adopting the atomic layer deposition process, the first electrode layer 30 and the extension part 40, that are of an integrated structure, are formed on the side wall of the capacitive hole 31, in the annular groove 80 and on the top surface of the connection pad 20. Herein, the extension part 40 covers the top surface of the connection pad 20 and the side surface of the connection pad 20, so that a contact area between the first electrode layer 30 and the connection pad 20 may be increased, contact resistance between the first electrode layer 30 and the connection pad 20 may be reduced, thus signal delay is reduced, and the performance of the DRAM is improved. Moreover, the extension part 40 may also improve the acting force between the capacitive hole and the connection pad, so that the collapse risk of the capacitor in a subsequent manufacturing process is reduced.

Moreover, the materials of the first electrode layer 30 and the extension part 40 may be one or a compound formed by metal nitride and metal silicide, such as titanium nitride, titanium silicide or titanium silicon nitride.

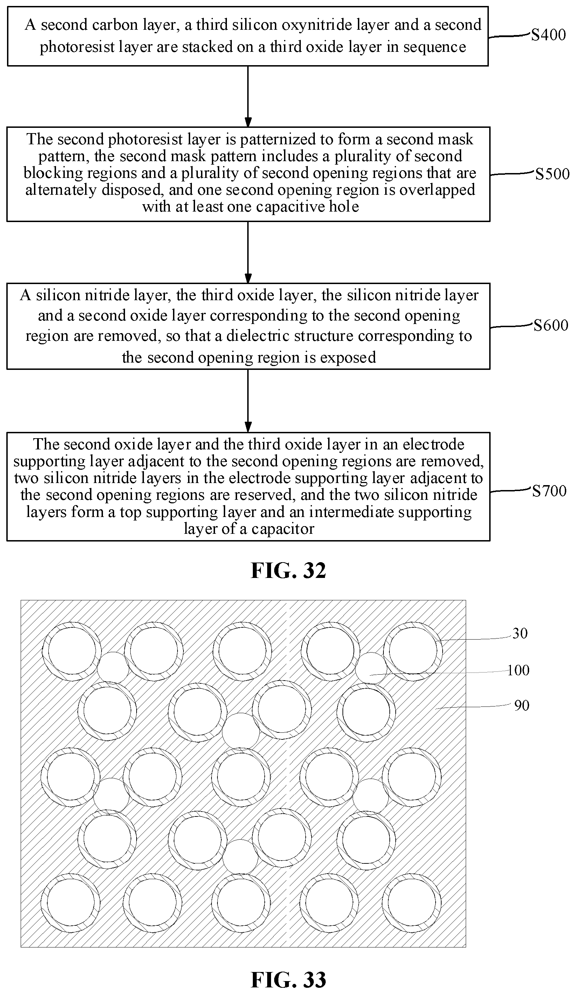

After the steps of forming the first electrode layer 30 in the capacitive hole 31 and forming the first extension part 40 in the annular groove 80, the operation may also include the following steps, as illustrated in FIG. 32.

At S400, a second carbon layer, a third silicon oxynitride layer and a second photoresist layer are stacked on the third oxide layer in sequence.

At S500, the second photoresist layer is patternized to form a second mask pattern, the second mask pattern may include a plurality of second blocking regions and a plurality of second opening regions that are alternately disposed, and one second opening region is overlapped with at least one capacitive hole.

Herein, the second opening region is overlapped with a plurality of capacitive holes. For example, as illustrated in FIG. 33, the DRAM provided by the embodiments may include a plurality of capacitive holes, every three capacitive holes form a triangular capacitive hole group, a plurality of capacitive hole groups are distributed on the dielectric structure at intervals, and the center of the second opening region is superposed with the center of the triangular capacitive hole group.

At S600, the silicon nitride layer, the third oxide layer, the silicon nitride layer and the second oxide layer corresponding to the second opening region are removed, so that the dielectric structure 50 corresponding to the second opening region 100 is exposed.

In the step, under other conditions, part of second electrode layer corresponding to the second opening region may also be removed.

At S700, the second oxide layer and the third oxide layer in the electrode supporting layer adjacent to the second opening region are removed, two silicon nitride layers in the electrode supporting layer adjacent to the second opening region are reserved, and the two silicon nitride layers form a top supporting layer and an intermediate supporting layer of the capacitor, thereby forming a structure as illustrated in FIG. 2 and FIG. 3.

According to the manufacturing method of the DRAM provided by the embodiments of the present disclosure, the extension part extending towards the substrate is formed on the first electrode layer, and the extension part is coated on the top surface and the side surface of the connection pad at the same time. Compared with the technical solution that the extension part is only coated on the top surface of the connection pad, the extension part in the embodiments of the present disclosure increases an contact area between the first electrode layer and the connection pad, reduces contact resistance between the first electrode layer and the connection pad, thus reduces signal delay of the DRAM, and improves the performance of the DRAM.

Various embodiments or implementation modes in the specification are described in a progressive way, each of the embodiments focuses on the differences from other embodiments, and same and similar parts among various embodiments may be referred to each other.

In descriptions of the specification, description of referring terms such as "one implementation mode", "some implementation modes", "a schematic implementation mode", "a demonstration", "a specific demonstration", or "some demonstrations" refers to specific features, structures, materials or features described in combination with the implementation modes or demonstrations involved in at least one implementation mode or demonstration of the present disclosure. In the specification, schematic description on the above terms not always refers to same embodiment modes or demonstrations. Moreover, the described specific features, structures, materials or features may be combined in any one or more implementation modes or demonstrations in a proper manner.

Finally, it is to be noted that the above various embodiments are only used to illustrate the technical solutions of the present disclosure, and are not limited thereto. Although the present disclosure has been described in detail with reference to the foregoing various embodiments, those skilled in the art should understand that the technical solutions described in the foregoing various embodiments still may be modified.

## Claims

1. A manufacturing method of a Dynamic Random Access Memory (DRAM), comprising steps of:
providing a substrate (10);
forming connection pads (20) on the substrate (10), each connection pad (20) having a bottom surface towards the substrate (10) and a top surface away from the substrate (10), and the bottom surface of the connection pad (20) making contact with the substrate (10); and
forming capacitors on respective connection pads (20), each capacitor having a first electrode layer (30), the first electrode layer (30) having an extension part (40) extending towards the substrate (10), and the extension part (40) covering a top surface and a side surface of a respective connection pad (20), wherein
before the step of forming the connection pads (20) on the substrate (10), the manufacturing method further comprises: forming a dielectric structure (50) on the substrate (10);
the step of forming the capacitors on the respective connection pads (20) comprises:
forming a first stacked structure (70) on the dielectric structure (50);
forming annular grooves (80) penetrating through the first stacked structure (70) and extending into the dielectric structure (50);
forming a filler layer (81) in each annular groove (80), an upper surface of the filler layer (81) being aligned to an upper surface of the first stacked structure (70);
forming a second stacked structure (90) on the first stacked structure (70);
forming capacitive holes (31) penetrating through the second stacked structure (90) and extending to top surfaces of respective connection pads (20), and removing the filler layers (81) in the annular grooves (80), so that an end, towards the substrate (10), of each capacitive hole (31) is communicated with the respective annular groove (80); and
forming the first electrode layer (30) in each capacitive hole (31) and forming the extension part (40) in each annular groove (80), the bottom of the first electrode layer (30) being electrically connected with a top surface of the connection pad (20), and the extension part (40) covering the top surface of the connection pad (20) and the side surface of the connection pad (20) and forming an integrated structure with the first electrode layer (30).

2. The manufacturing method of the DRAM according to claim 1, wherein
the step of forming the annular grooves (80) penetrating through the first stacked structure (70) and extending into the dielectric structure (50) comprises:
forming a plurality of first protusions (75) disposed at intervals on the first stacked structure (70), the first protusion (75) corresponding to the respective connection pads (20), and in a horizontal direction, the width of the first protusion (75) being equal to the width of the connection pad (20);
forming an etching layer (76) on the first stacked structure (70), an etching ratio of the etching layer (76) being greater than an etching ratio of the first stacked structure (70); and
removing the first protusions (75) and the etching layer (76) to form the annular grooves (80) penetrating through the first stacked structure (70) and extending to the dielectric structure (50), each annular groove (80) being configured to surround the side surface of the respective connection pad (20), part of inner side surface of the annular groove (80) being superposed with the side surface of the respective connection pad (20), and in the horizontal direction, a width of the annular groove (80) being equal to a width of the etching layer (76).

3. The manufacturing method of the DRAM according to claim 1, wherein
the step of forming the annular grooves (80) penetrating through the first stacked structure (70) and extending into the dielectric structure (50) comprises:
forming a plurality of first protusions (75) disposed at intervals on the first stacked structure (70), each first protusion (70) corresponding to a respective connection pad (20), and in a horizontal direction, the width of the first protusion (75) being less than the width of the connection pad (20);
forming an etching layer (76) on the first stacked structure (70), an etching ratio of the etching layer (76) being greater than an etching ratio of the first stacked structure (70); and
removing the first protusions (75) and the etching laye (76)r to form the annular grooves (80) penetrating through the first stacked structure (70) and extending to the dielectric structure (50), each annular groove (80) surrounding a side surface of the respective connection pad (20) and exposing part of top surface of the respective connection pad (20), part of inner side surface of the annular groove (80) being superposed with the side surface of the respective connection pad (20), and in the horizontal direction, a width of the etching layer (76) being equal to a sum of: a difference between a width of the connection pad (20) and a width of the first protusion (75), and a width of the annular groove (80).

4. The manufacturing method of the DRAM according to claim 2 or 3, wherein
the step of forming the first stacked structure (70) on the dielectric structure (50) comprises: forming a first oxide layer (71), a first mask layer (72) and a first silicon oxynitride layer (73) on the dielectric structure (50) in a sequentially stacked manner;
the step of forming the plurality of first protusions (75) disposed at intervals on the first stacked structure (70) comprises:
forming a first photoresist layer (74) on the first silicon oxynitride layer (73);
patterning the first photoresist layer (74) to form a first mask pattern, the first mask pattern comprising a plurality of first blocking regions (741) and a plurality of first opening regions (742) that are alternately disposed, and the plurality of first blocking regions (741) and the connection pads (20) being in one-to-one correspondence; and
removing the first mask layer (72) and the first silicon oxynitride layer (73) corresponding to the first opening regions (742) to form the plurality of first protusions (75) disposed on the first oxide layer (71) at intervals, the plurality of first protusions (75) and the connection pads (20) being in correspondence.

5. The manufacturing method of the DRAM according to claim 4, wherein the step of forming a second stacked structure (90) on the first stacked structure (70) comprises:
forming an electrode supporting layer (91), a sacrificial layer (92) and a mask layer group (93) on the first stacked structure (70) in a sequentially stacked manner, an etching ratio of the electrode supporting layer (91) being greater than an etching ratio of the sacrificial layer (92), and the etching ratio of the sacrificial layer (92) being greater than an etching ratio of the mask layer group (93);
the step of forming capacitive holes (31) penetrating through the second stacked structure (90) and extending to a top surface of the connection pad (20), and removing the filler layer (81) in the annular grooves (80), so that an end, towards the substrate (10), of each capacitive hole (31) is communicated with the respective annular groove (80), comprises:
forming a plurality of second protusions disposed at intervals on the electrode supporting layer (91), and forming an opening (924) by a region between adjacent second protusions, the opening (924) corresponding to the respective connection pad (20) and the respective filler layer (81);
removing the second protusions, the electrode supporting layer (91) corresponding to the openings (924) and the first stacked structure (70) to form the capacitive holes (31) penetrating through the electrode supporting layer (91) and the first stacked structure (70); and
removing the dielectric structure (50) and the filler layer (81) located between top surfaces of the connection pads (20) and the first stacked structure (70) to form the annular grooves (80) configured to set extension parts (40).

6. The manufacturing method of the DRAM according to claim 5, wherein the step of forming the electrode supporting layer (91), the sacrificial layer (92) and the mask layer group (93) on the first stacked structure (70) in a sequentially stacked manner comprises:
forming a second oxide layer (911), a silicon nitride layer (912), a third oxide layer (913) and a silicon nitride layer (912) on the first stacked structure (70) in a sequentially stacked manner;
sequentially stacking a polycrystalline silicon layer (921), a fourth oxide layer (922) and a first carbon layer (923) on a side surface, departing from the third oxide layer (913), of the silicon nitride layer (912); and
sequentially stacking a second silicon oxynitride layer (931), a second mask layer (932), a second silicon oxynitride layer (931) and a second mask layer (932) on the first carbon layer (923).

7. The manufacturing method of the DRAM according to claim 6, wherein after the step of forming a first electrode layer (30) in capacitive holes (31) and forming extension parts (40) in an annular grooves (80), the manufacturing method further comprises:
sequentially stacking a second carbon layer, a third silicon oxynitride layer and a second photoresist layer on the third oxide layer;
patterning the second photoresist layer to form a second mask pattern, the second mask pattern comprising a plurality of second blocking regions and a plurality of second opening regions (100) that are alternately disposed, and one second opening region (100) being overlapped with at least one capacitive hole (31);
removing the silicon nitride layer (912), the third oxide layer (913), the silicon nitride layer (912) and the second oxide layer (911) corresponding to the second opening regions (100), so that the dielectric structure (50) corresponding to the second opening regions (100) is exposed, and part of second electrode layer corresponding to the second opening regions (100) is removed; and
removing the second oxide layer (911) and the third oxide layer (913) in the electrode supporting layer (91) adjacent to the second opening regions (100), and retaining two silicon nitride layers (912) in the electrode supporting layer (91) adjacent to the second opening regions (100).

## Patentansprüche

1. Herstellungsverfahren für einen dynamischen Speicher mit wahlfreiem Zugriff (DRAM), umfassend die folgenden Schritte:
Bereitstellen eines Substrats (10);
Ausbilden von Verbindungspads (20) auf dem Substrat (10), wobei jedes Verbindungspad (20) eine dem Substrat (10) zugewandte Unterseite und eine vom Substrat (10) abgewandte Oberseite aufweist und die Unterseite des Verbindungspads (20) Kontakt mit dem Substrat (10) herstellt; und
Ausbilden von Kondensatoren auf jeweiligen Verbindungspads (20), wobei jeder Kondensator eine erste Elektrodenschicht (30) aufweist, wobei die erste Elektrodenschicht (30) einen Erstreckungsteil (40) aufweist, der sich zum Substrat (10) hin erstreckt, und wobei der Erstreckungsteil (40) eine Oberseite und eine Seitenfläche eines jeweiligen Verbindungspads (20) bedeckt, wobei
vor dem Schritt des Ausbildens der Verbindungspads (20) auf dem Substrat (10) das Herstellungsverfahren ferner Folgendes Folgendes umfasst: Ausbilden einer dielektrischen Struktur (50) auf dem Substrat (10);
der Schritt des Ausbildens der Kondensatoren auf den jeweiligen Verbindungspads (20) Folgendes umfasst:
Ausbilden einer ersten gestapelten Struktur (70) auf der dielektrischen Struktur (50);
Ausbilden ringförmiger Nuten (80), die die erste gestapelte Struktur (70) durchdringen und sich in die dielektrische Struktur (50) erstrecken;
Ausbilden einer Füllerschicht (81) in jeder ringförmigen Nut (80), wobei eine obere Oberfläche der Füllerschicht (81) an einer oberen Oberfläche der ersten gestapelten Struktur (70) ausgerichtet ist;
Ausbilden einer zweiten gestapelten Struktur (90) auf der ersten gestapelten Struktur (70);
Ausbilden kapazitiver Löcher (31), die die zweite gestapelte Struktur (90) durchdringen und sich bis zu den Oberseiten jeweiliger Verbindungspads (20) erstrecken, und Entfernen der Füllerschichten (81) in den ringförmigen Nuten (80), so dass ein zum Substrat (10) hin weisendes Ende jedes kapazitiven Lochs (31) mit der jeweiligen ringförmigen Nut (80) in Verbindung steht; und
Ausbilden der ersten Elektrodenschicht (30) in jedem kapazitiven Loch (31) und Ausbilden des Erstreckungsteils (40) in jeder ringförmigen Nut (80), wobei der Boden der ersten Elektrodenschicht (30) elektrisch mit einer Oberseite des Verbindungspads (20) verbunden ist, und wobei der Erstreckungsteil (40) die Oberseite des Verbindungspads (20) und die Seitenfläche des Verbindungspads (20) bedeckt und eine integrierte Struktur mit der ersten Elektrodenschicht (30) bildet.

2. Herstellungsverfahren für den DRAM nach Anspruch 1, wobei
der Schritt des Ausbildens der ringförmigen Nuten (80), die die erste gestapelte Struktur (70) durchdringen und sich in die dielektrische Struktur (50) erstrecken, Folgendes umfasst:
Ausbilden einer Vielzahl von ersten Vorsprüngen (75), die in Abständen auf der ersten gestapelten Struktur (70) angeordnet sind, wobei der erste Vorsprung (75) den jeweiligen Verbindungspads (20) entspricht und in einer horizontalen Richtung die Breite des ersten Vorsprungs (75) gleich der Breite des Verbindungspads (20) ist;
Ausbilden einer Ätzschicht (76) auf der ersten gestapelten Struktur (70), wobei ein Ätzverhältnis der Ätzschicht (76) größer ist als ein Ätzverhältnis der ersten gestapelten Struktur (70); und
Entfernen der ersten Vorsprünge (75) und der Ätzschicht (76), um die ringförmigen Nuten (80) zu bilden, die die erste gestapelte Struktur (70) durchdringen und sich bis zur dielektrischen Struktur (50) erstrecken, wobei jede ringförmige Nut (80) so konfiguriert ist, dass sie die Seitenfläche des jeweiligen Verbindungspads (20) umgibt, wobei ein Teil der Innenseitenfläche der ringförmigen Nut (80) mit der Seitenfläche des jeweiligen Verbindungspads (20) überlagert ist und in der horizontalen Richtung eine Breite der ringförmigen Nut (80) gleich einer Breite der Ätzschicht (76) ist.

3. Herstellungsverfahren für den DRAM nach Anspruch 1, wobei
der Schritt des Ausbildens der ringförmigen Nuten (80), die die erste gestapelte Struktur (70) durchdringen und sich in die dielektrische Struktur (50) erstrecken, Folgendes umfasst:
Ausbilden einer Vielzahl von ersten Vorsprüngen (75), die in Abständen auf der ersten gestapelten Struktur (70) angeordnet sind, wobei jeder erste Vorsprung (70) einem jeweiligen Verbindungspad (20) entspricht und in einer horizontalen Richtung die Breite des ersten Vorsprungs (75) kleiner ist als die Breite des Verbindungspads (20);
Ausbilden einer Ätzschicht (76) auf der ersten gestapelten Struktur (70), wobei ein Ätzverhältnis der Ätzschicht (76) größer ist als ein Ätzverhältnis der ersten gestapelten Struktur (70); und
Entfernen der ersten Vorsprünge (75) und der Ätzschicht (76), um die ringförmigen Nuten (80) zu bilden, die die erste gestapelte Struktur (70) durchdringen und sich bis zur dielektrischen Struktur (50) erstrecken, wobei jede ringförmige Nut (80) eine Seitenfläche des jeweiligen Verbindungspads (20) umgibt und einen Teil der Oberseite des jeweiligen Verbindungspads (20) freilegt, wobei ein Teil der Innenseitenfläche der ringförmigen Nut (80) mit der Seitenfläche des jeweiligen Verbindungspads (20) überlagert ist und in der horizontalen Richtung eine Breite der Ätzschicht (76) gleich einer Summe aus einer Differenz zwischen einer Breite des Verbindungspads (20) und einer Breite des ersten Vorsprungs (75) und einer Breite der ringförmigen Nut (80) ist.

4. Herstellungsverfahren für den DRAM nach Anspruch 2 oder 3, wobei
der Schritt des Ausbildens der ersten gestapelten Struktur (70) auf der dielektrischen Struktur (50) Folgendes umfasst: Ausbilden einer ersten Oxidschicht (71), einer ersten Maskenschicht (72) und einer ersten Siliziumoxynitridschicht (73) auf der dielektrischen Struktur (50) in einer sequenziell gestapelten Weise;
der Schritt des Ausbildens der mehreren ersten Vorsprünge (75), die in Abständen auf der ersten gestapelten Struktur (70) angeordnet sind, Folgendes umfasst:
Ausbilden einer ersten Fotolackschicht (74) auf der ersten Siliziumoxynitridschicht (73);
Strukturieren der ersten Fotolackschicht (74), um ein erstes Maskenmuster zu bilden, wobei das erste Maskenmuster eine Vielzahl von ersten Sperrbereichen (741) und eine Vielzahl von ersten Öffnungsbereichen (742) umfasst, die abwechselnd angeordnet sind, und wobei die Vielzahl von ersten Sperrbereichen (741) und die Verbindungspads (20) in einer Eins-zu-Eins-Entsprechung stehen; und
Entfernen der ersten Maskenschicht (72) und der ersten Siliziumoxynitridschicht (73) entsprechend den ersten Öffnungsbereichen (742), um die Vielzahl von ersten Vorsprüngen (75) zu bilden, die in Abständen auf der ersten Oxidschicht (71) angeordnet sind, wobei die Vielzahl von ersten Vorsprüngen (75) und die Verbindungspads (20) in Korrespondenz stehen.

5. Herstellungsverfahren für den DRAM nach Anspruch 4, wobei der Schritt des Ausbildens einer zweiten gestapelten Struktur (90) auf der ersten gestapelten Struktur (70) Folgendes umfasst:
Ausbilden einer Elektrodenstützschicht (91), einer Opferschicht (92) und einer Maskenschichtgruppe (93) auf der ersten gestapelten Struktur (70) in einer sequenziell gestapelten Weise, wobei ein Ätzverhältnis der Elektrodenstützschicht (91) größer als ein Ätzverhältnis der Opferschicht (92) und das Ätzverhältnis der Opferschicht (92) größer als ein Ätzverhältnis der Maskenschichtgruppe (93) ist;
der Schritt des Ausbildens kapazitiver Löcher (31), die die zweite gestapelte Struktur (90) durchdringen und sich bis zu einer Oberseite des Verbindungspads (20) erstrecken, und des Entfernens der Füllerschicht (81) in den ringförmigen Nuten (80), so dass ein zum Substrat (10) hin weisendes Ende jedes kapazitiven Lochs (31) mit der jeweiligen ringförmigen Nut (80) in Verbindung steht, Folgendes umfasst:
Ausbilden einer Vielzahl von zweiten Vorsprüngen, die in Abständen auf der Elektrodenstützschicht (91) angeordnet sind, und Ausbilden einer Öffnung (924) durch einen Bereich zwischen benachbarten zweiten Vorsprüngen, wobei die Öffnung (924) dem jeweiligen Verbindungspad (20) und der jeweiligen Füllerschicht (81) entspricht;
Entfernen der zweiten Vorsprünge, der den Öffnungen (924) entsprechenden Elektrodenstützschicht (91) und der ersten gestapelten Struktur (70), um die kapazitiven Löcher (31) zu bilden, die die Elektrodenstützschicht (91) und die erste gestapelte Struktur (70) durchdringen; und
Entfernen der dielektrischen Struktur (50) und der Füllerschicht (81), die sich zwischen den Oberseiten der Verbindungspads (20) und der ersten gestapelten Struktur (70) befinden, um die ringförmigen Nuten (80) zu bilden, die zum Setzen der Erstreckungsteile (40) konfiguriert sind.

6. Herstellungsverfahren für den DRAM nach Anspruch 5, wobei der Schritt des Ausbildens der Elektrodenstützschicht (91), der Opferschicht (92) und der Maskenschichtgruppe (93) auf der ersten gestapelten Struktur (70) in einer sequenziell gestapelten Weise Folgendes umfasst:
Ausbilden einer zweiten Oxidschicht (911), einer Siliziumnitridschicht (912), einer dritten Oxidschicht (913) und einer Siliziumnitridschicht (912) auf der ersten gestapelten Struktur (70) in einer sequenziell gestapelten Weise;
sequentielles Stapeln einer polykristallinen Siliziumschicht (921), einer vierten Oxidschicht (922) und einer ersten Kohlenstoffschicht (923) auf einer von der dritten Oxidschicht (913) abgewandten Seitenfläche der Siliziumnitridschicht (912); und
sequenzielles Stapeln einer zweiten Siliziumoxynitridschicht (931), einer zweiten Maskenschicht (932), einer zweiten Siliziumoxynitridschicht (931) und einer zweiten Maskenschicht (932) auf der ersten Kohlenstoffschicht (923).

7. Herstellungsverfahren für den DRAM nach Anspruch 6, wobei nach dem Schritt des Ausbildens einer ersten Elektrodenschicht (30) in kapazitiven Löchern (31) und des Ausbildens von Erstreckungsteilen (40) in ringförmigen Nuten (80) das Herstellungsverfahren ferner Folgendes umfasst:
sequentielles Stapeln einer zweiten Kohlenstoffschicht, einer dritten Siliziumoxynitridschicht und einer zweiten Fotolackschicht auf der dritten Oxidschicht;
Strukturieren der zweiten Fotolackschicht, um ein zweites Maskenmuster zu bilden, wobei das zweite Maskenmuster eine Vielzahl von zweiten Sperrbereichen und eine Vielzahl von zweiten Öffnungsbereichen (100) umfasst, die abwechselnd angeordnet sind, und wobei sich ein zweiter Öffnungsbereich (100) mit mindestens einem kapazitiven Loch (31) überlappt;
Entfernen der Siliziumnitridschicht (912), der dritten Oxidschicht (913), der Siliziumnitridschicht (912) und der zweiten Oxidschicht (911), die den zweiten Öffnungsbereichen (100) entsprechen, so dass die dielektrische Struktur (50), die den zweiten Öffnungsbereichen (100) entspricht, freigelegt wird und ein Teil der zweiten Elektrodenschicht, der den zweiten Öffnungsbereichen (100) entspricht, entfernt wird; und
Entfernen der zweiten Oxidschicht (911) und der dritten Oxidschicht (913) in der Elektrodenstützschicht (91) neben den zweiten Öffnungsbereichen (100) und Beibehalten zweier Siliziumnitridschichten (912) in der Elektrodenstützschicht (91) neben den zweiten Öffnungsbereichen (100).

## Revendications

1. Procédé de fabrication d'une mémoire vive dynamique (DRAM), comprenant les étapes suivantes :
fournir un substrat (10) ;
former des plots de connexion (20) sur le substrat (10), chaque plot de connexion (20) ayant une surface inférieure vers le substrat (10) et une surface supérieure éloignée du substrat (10), et la surface inférieure du plot de connexion (20) étant en contact avec le substrat (10) ; et
former des condensateurs sur les plots de connexion (20) respectifs, chaque condensateur ayant une première couche d'électrode (30), la première couche d'électrode (30) ayant une partie d'extension (40) s'étendant vers le substrat (10), et la partie d'extension (40) recouvrant une surface supérieure et une surface latérale d'un plot de connexion (20) respectif, dans lequel,
avant l'étape de formation des plots de connexion (20) sur le substrat (10), le procédé de fabrication comprend en outre : former une structure diélectrique (50) sur le substrat (10) ;
l'étape de formation des condensateurs sur les plots de connexion (20) respectifs comprend :
former une première structure empilée (70) sur la structure diélectrique (50) ;
former des rainures annulaires (80) pénétrant à travers la première structure empilée (70) et s'étendant jusqu'à l'intérieur de la structure diélectrique (50) ;
former une couche de remplissage (81) dans chaque rainure annulaire (80), une surface supérieure de la couche de remplissage (81) étant alignée avec une surface supérieure de la première structure empilée (70) ;
former une seconde structure empilée (90) sur la première structure empilée (70) ;
former des trous capacitifs (31) pénétrant à travers la seconde structure empilée (90) et s'étendant vers des surfaces supérieures des plots de connexion (20) respectifs, et éliminer les couches de remplissage (81) dans les rainures annulaires (80), de sorte qu'une extrémité, vers le substrat (10), de chaque trou capacitif (31) soit communiquée avec la rainure annulaire (80) respective ; et
former la première couche d'électrode (30) dans chaque trou capacitif (31) et former la partie d'extension (40) dans chaque rainure annulaire (80), le fond de la première couche d'électrode (30) étant connecté électriquement à une surface supérieure du plot de connexion (20), et la partie d'extension (40) recouvrant la surface supérieure du plot de connexion (20) et la surface latérale du plot de connexion (20) et formant une structure intégrée avec la première couche d'électrode (30).

2. Procédé de fabrication de la DRAM selon la revendication 1, dans lequel
l'étape de formation des rainures annulaires (80) pénétrant à travers la première structure empilée (70) et s'étendant jusqu'à l'intérieur de la structure diélectrique (50) comprend :
former une pluralité de premières protubérances (75) disposées à intervalles sur la première structure empilée (70), la première protubérance (75) correspondant aux plots de connexion (20) respectifs, et dans une direction horizontale, la largeur de la première protubérance (75) étant égale à la largeur du plot de connexion (20) ;
former une couche de gravure (76) sur la première structure empilée (70), un ratio de gravure de la couche de gravure (76) étant supérieur à un ratio de gravure de la première structure empilée (70) ; et
éliminer les premières protubérances (75) et la couche de gravure (76) pour former les rainures annulaires (80) pénétrant à travers la première structure empilée (70) et s'étendant vers la structure diélectrique (50), chaque rainure annulaire (80) étant configurée pour entourer la surface latérale du plot de connexion (20) respectif, une partie de la surface latérale interne de la rainure annulaire (80) étant superposée à la surface latérale du plot de connexion (20) respectif, et dans la direction horizontale, une largeur de la rainure annulaire (80) étant égale à une largeur de la couche de gravure (76).

3. Procédé de fabrication de la DRAM selon la revendication 1, dans lequel
l'étape de formation des rainures annulaires (80) pénétrant à travers la première structure empilée (70) et s'étendant jusqu'à l'intérieur de la structure diélectrique (50) comprend :
former une pluralité de premières protubérances (75) disposées à intervalles sur la première structure empilée (70), chaque première protubérance (70) correspondant à un plot de connexion (20) respectif, et dans une direction horizontale, la largeur de la première protubérance (75) étant inférieure à la largeur du plot de connexion (20) ;
former une couche de gravure (76) sur la première structure empilée (70), un ratio de gravure de la couche de gravure (76) étant supérieur à un ratio de gravure de la première structure empilée (70) ; et
éliminer les premières protubérances (75) et la couche de gravure (76) pour former les rainures annulaires (80) pénétrant à travers la première structure empilée (70) et s'étendant vers la structure diélectrique (50), chaque rainure annulaire (80) entourant une surface latérale du plot de connexion (20) respectif et exposant une partie d'une surface supérieure du plot de connexion (20) respectif, une partie d'une surface latérale interne de la rainure annulaire (80) étant superposée à la surface latérale du plot de connexion (20) respectif, et dans la direction horizontale, une largeur de la rainure de gravure (76) étant égale à une somme de : une différence entre une largeur du plot de connexion (20) et une largeur de la première protubérance (75), et une largeur de la rainure annulaire (80).

4. Procédé de fabrication de la DRAM selon la revendication 2 ou 3, dans lequel
l'étape de formation de la première structure empilée (70) sur la structure diélectrique (50) comprend : former une première couche d'oxyde (71), une première couche de masque (72) et une première couche d'oxynitrure de silicium (73) sur la structure diélectrique (50) en les empilant en séquence ;
l'étape de formation de la pluralité de premières protubérances (75) disposées à intervalles sur la première structure empilée (70) comprend :
former une première couche photorésistante (74) sur la première couche d'oxynitrure de silicium (73) ;
former des motifs sur la première couche photorésistante (74) pour former un premier motif de masque, le premier motif de masque comprenant une pluralité de premières régions de blocage (741) et une pluralité de premières régions d'ouverture (742) disposées de manière alternative, et la pluralité de premières régions de blocage (741) et les plots de connexion (20) étant en correspondance biunivoque ; et
éliminer la première couche de masque (72) et la première couche d'oxynitrure de silicium (73) correspondant aux premières régions d'ouverture (742) afin de former la pluralité de premières protubérances (75) disposées sur la première couche d'oxyde (71) à intervalles, la pluralité de premières protubérances (75) et les plots de connexion (20) étant en correspondance.

5. Procédé de fabrication de la DRAM selon la revendication 4, dans lequel l'étape de formation d'une seconde structure empilée (90) sur la première structure empilée (70) comprend :
former une couche de support d'électrode (91), une couche sacrificielle (92) et un groupe de couches de masque (93) sur la première structure empilée (70) en les empilant en séquence, un rapport de gravure de la couche de support d'électrode (91) étant supérieur à un rapport de gravure de la couche sacrificielle (92), et le rapport de gravure de la couche sacrificielle (92) étant supérieur à un rapport de gravure du groupe de couches de masque (93) ;
l'étape de formation des trous capacitifs (31) pénétrant à travers la seconde structure empilée (90) et s'étendant vers une surface supérieure des plots de connexion (20) respectifs, et d'élimination des couches de remplissage (81) dans les rainures annulaires (80), de sorte qu'une extrémité, vers le substrat (10), de chaque trou capacitif (31) soit communiquée avec la rainure annulaire (80) respective, comprend :
former une pluralité de secondes protubérances disposées à intervalles sur la couche de support d'électrode (91), et former une ouverture (924) par une région entre des secondes protubérances adjacentes, l'ouverture (924) correspondant au plot de connexion (20) respectif et à la couche de remplissage (81) respective ;
éliminer les secondes protubérances, la couche de support d'électrode (91) correspondant aux ouvertures (924) et la première structure empilée (70) pour former les trous capacitifs (31) pénétrant à travers la couche de support d'électrode (91) et la première structure empilée (70) ; et
éliminer la structure diélectrique (50) et la couche de remplissage (81) situées entre des surfaces supérieures des plots de connexion (20) et la première structure empilée (70) pour former les rainures annulaires (80) configurées pour accueillir les parties d'extension (40).

6. Procédé de fabrication de la DRAM selon la revendication 5, dans lequel l'étape de formation de la couche de support d'électrode (91), de la couche sacrificielle (92) et du groupe de couches de masque (93) sur la première structure empilée (70) en les empilant en séquence comprend :
former une deuxième couche d'oxyde (911), une couche de nitrure de silicium (912), une troisième couche d'oxyde (913) et une couche de nitrure de silicium (912) sur la première structure empilée (70) en les empilant en séquence ;
empiler en séquence une couche de silicium polycristallin (921), une quatrième couche d'oxyde (922) et une première couche de carbone (923) sur une surface latérale, à partir de la troisième couche d'oxyde (913), de la couche de nitrure de silicium (912) ; et
empiler en séquence une deuxième couche d'oxynitrure de silicium (931), une deuxième couche de masque (932), une deuxième couche d'oxynitrure de silicium (931) et une deuxième couche de masque (932) sur la première couche de carbone (923).

7. Procédé de fabrication de la DRAM selon la revendication 6, dans lequel après l'étape de formation d'une première couche d'électrode (30) dans des trous capacitifs (31) et de formation de parties d'extension (40) dans des rainures annulaires (80), le procédé de fabrication comprend en outre :
empiler en séquence une deuxième couche de carbone, une troisième couche d'oxynitrure de silicium et une deuxième couche photorésistante sur la troisième couche d'oxyde ;
former des motifs sur la deuxième couche photorésistante pour former un deuxième motif de masque, le deuxième motif de masque comprenant une pluralité de deuxièmes régions de blocage et une pluralité de deuxièmes régions d'ouverture (100) disposées de manière alternative, et une deuxième région d'ouverture (100) étant chevauchée avec au moins un trou capacitif (31) ;
éliminer la couche de nitrure de silicium (912), la troisième couche d'oxyde (913), la couche de nitrure de silicium (912) et la deuxième couche d'oxyde (911) correspondant aux deuxièmes régions d'ouverture (100), de sorte que la structure diélectrique (50) correspondant aux deuxièmes régions d'ouverture (100) soit exposée, et qu'une partie de la deuxième couche d'électrode correspondant aux deuxièmes régions d'ouverture (100) soit éliminée ; et
éliminer la deuxième couche d'oxyde (911) et la troisième couche d'oxyde (913) dans la couche de support d'électrode (91) adjacente aux deuxièmes régions d'ouverture (100), et garder deux couches de nitrure de silicium (912) dans la couche de support d'électrode (91) adjacente aux deuxièmes régions d'ouverture (100).
